# EUROPEAN PATENT APPLICATION

(11) **EP 4 709 085 A1**
(43) Date of publication of application: **11.03.2026**
(21) Application number: 25200604.4
(22) Date of filing: 05.09.2025
(51) Int. Cl.: H10D 62/10, H10D 30/01, H10D 30/66, H10D 62/832, H10P 30/20, H10P 30/22

(54) **POWER SEMICONDUCTOR DEVICES AND METHODS OF FABRICATING THE SAME**

(30) Priority: 10.09.2024 KR 20240123273
(71) Applicant: Samsung Electronics Co., Ltd., Suwon-si, Gyeonggi-do 16677 (KR)
(72) Inventor: KIM, Taehun, 16677 Suwon-si (KR); KO, Mingu, 16677 Suwon-si (KR); OH, Sewoong, 16677 Suwon-si (KR); PARK, Younghwan, 16677 Suwon-si (KR); WOO, Sangsu, Suwon-si (KR); PARK, Jeonghwan, 16677 Suwon-si (KR)
(74) Representative: Marks & Clerk LLP

(57) **Abstract**

A semiconductor device includes a substrate of a first conductivity type, a drift layer of the first conductivity type on the substrate, a well region of a second conductivity type on the drift layer, a source region of the first conductivity type on the well region, a gate trench extending through the source region and the well region, and extending into the drift layer, a gate insulating layer in the gate trench, a gate electrode on the gate insulating layer, a shield region of the second conductivity type below the gate insulating layer and in a section of the gate trench that extends into the drift layer, and a cap region of the first conductivity type on a side of the shield region and in the section of the gate trench that extends into the drift layer.

## Description

### BACKGROUND

The present disclosure relates to power semiconductor devices and methods of fabricating the same.

Power semiconductor devices are semiconductor devices that operate in high-voltage and high-current environments, and are used in fields requiring high-power switching, such as power conversion, power converters, and inverters. Power semiconductor devices may be fundamentally required to have characteristics enabling them to withstand high-voltages, and recently, high-speed switching operations have been additionally required. Accordingly, power semiconductor devices using SiC, having superior voltage withstand characteristics compared to Si, are being studied.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a power semiconductor device having improved electrical characteristics.

One or more example embodiments provide a method of manufacturing a power semiconductor device having improved electrical characteristics.

Additional aspects will be set forth in part in the description which follows and, in part, will be apparent from the description, or may be learned by practice of the presented embodiments.

According to an aspect of one or more embodiments, a semiconductor device may include a substrate of a first conductivity type, a drift layer of the first conductivity type on the substrate, a well region of a second conductivity type on the drift layer, a source region of the first conductivity type on the well region, a gate trench extending through the source region and the well region, and extending into the drift layer, a gate insulating layer in the gate trench, a gate electrode on the gate insulating layer, a shield region of the second conductivity type below the gate insulating layer and in a section of the gate trench that extends into the drift layer, a cap region of the first conductivity type on a side of the shield region and in the section of the gate trench that extends into the drift layer, a source electrode connected to the source region, and a drain electrode on a lower surface of the substrate.

According to an aspect of one or more embodiments, a semiconductor device may include a silicon carbide (SiC) substrate of a first conductivity type, a drift layer of the first conductivity type on the SiC substrate, a well region of a second conductivity type on the drift layer, a source region of the first conductivity type on the well region, a gate trench extending through the source region and the well region, and extending into the drift layer, a gate insulating layer in the gate trench, a gate electrode on the gate insulating layer, a cap region of the first conductivity type below the gate insulating layer and in a section of the gate trench that extends into the drift layer, the cap region including an edge portion extending toward the well region, a shield region of the second conductivity type within the cap region, below the gate insulating layer and contacting the gate insulating layer, a source electrode connected to the source region, and a drain electrode on a lower surface of the SiC substrate.

According to an aspect of one or more embodiments, a semiconductor device may include a substrate of a first conductivity type, a drift layer of the first conductivity type on the substrate, a plurality of cell stacks spaced apart by an interval on the drift layer, each of the plurality of cell stacks comprising a well region of a second conductivity type and a source region of the first conductivity type on the well region, a plurality of gate trenches extending into the drift layer and respectively extending through the source regions and the well regions of the plurality of cell stacks, a gate insulating layer on side surfaces of the plurality of cell stacks, a plurality of gate electrodes on the gate insulating layer, a plurality of cap regions of the first conductivity type below the gate insulating layer and in a section of respective gate trenches of the plurality of gate trenches that extends into the drift layer, each of the plurality of cap regions including at least one edge portion extending toward a respective well region of the plurality of cell stacks, a plurality of shield regions of the second conductivity type contacting the gate insulating layer and within respective cap regions of the plurality of cap regions, a source electrode connected to the source region of each of the plurality of cell stacks, and a drain electrode on a lower surface of the substrate.

According to an aspect of one or more embodiments, a method of manufacturing a semiconductor device may include forming a substrate structure including a substrate of a first conductivity type, a drift layer of the first conductivity type on the substrate, a well region of a second conductivity type on the drift layer, and a source region of the first conductivity type on the well region, forming a gate trench in the substrate structure using a mask, a region of the drift layer being open at a bottom of the gate trench, forming a cap region of the first conductivity type by ion-injecting a first conductivity-type impurity into the opened region of the drift layer, using the mask, removing the mask, forming a thermal oxide film on a surface of the substrate structure on which the gate trench is formed, and forming a shield region of the second conductivity type by ion-injecting a second conductivity-type impurity into a portion of the cap region of the first conductivity type, using the thermal oxide film.

At least some of the above and other features of the invention are set out in the claims.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a cross-sectional view illustrating a power semiconductor device according to one or more embodiments;
FIG. 2A and FIG. 2B are plan views illustrating the power semiconductor device illustrated in FIG. 1, taken along lines I1-I1' and I2-I2', according to one or more embodiments;
FIG. 3A to FIG. 3E are cross-sectional views illustrating a method of manufacturing a power semiconductor device illustrated in FIGS. 2A and 2B according to one or more embodiments;
FIG. 4 is a partially enlarged view illustrating area A of FIG. 3E according to one or more embodiments;
FIG. 5A to FIG. 5E are cross-sectional views illustrating a method of manufacturing a power semiconductor device according to one or more embodiments;
FIG. 6 is a cross-sectional view illustrating a power semiconductor device according to one or more embodiments;
FIG. 7A and FIG. 7B are plan views illustrating the power semiconductor device illustrated in FIG. 6, taken along lines III1-III1' and III2-III2', according to one or more embodiments;
FIG. 8 is a cross-sectional view of a power semiconductor device according to one or more embodiments;
FIG. 9 is a plan view of a power semiconductor device according to one or more embodiments;
FIG. 10 is a cross-sectional view of a power semiconductor device according to one or more embodiments; and
FIG. 11 is a cross-sectional view of a power semiconductor device according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

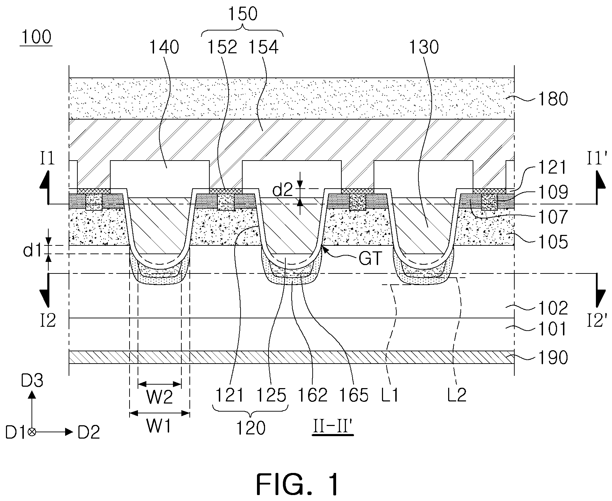

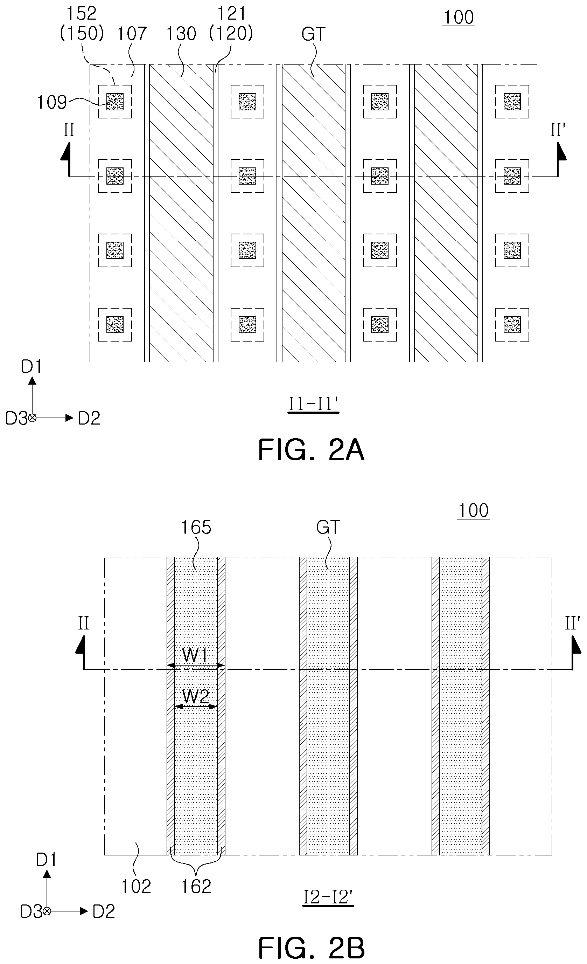

FIG. 1 is a cross-sectional view illustrating a power semiconductor device according to one or more embodiments. FIG. 2A and FIG. 2B are plan views illustrating the power semiconductor device illustrated in FIG. 1, taken along lines I1-I1' and I2-I2', according to one or more embodiments.

Referring to FIG. 1, a power semiconductor device 100 according to one or more embodiments may include a substrate 101, a drift layer 102 on the substrate 101, well regions 105 of a second conductivity type on the drift layer 102, source regions 107 of a first conductivity type respectively disposed on the well regions 105, and well contact regions 109 of a second conductivity type respectively connected (e.g. electrically connected and/or physically connected) to the well regions 105, within the source regions 107.

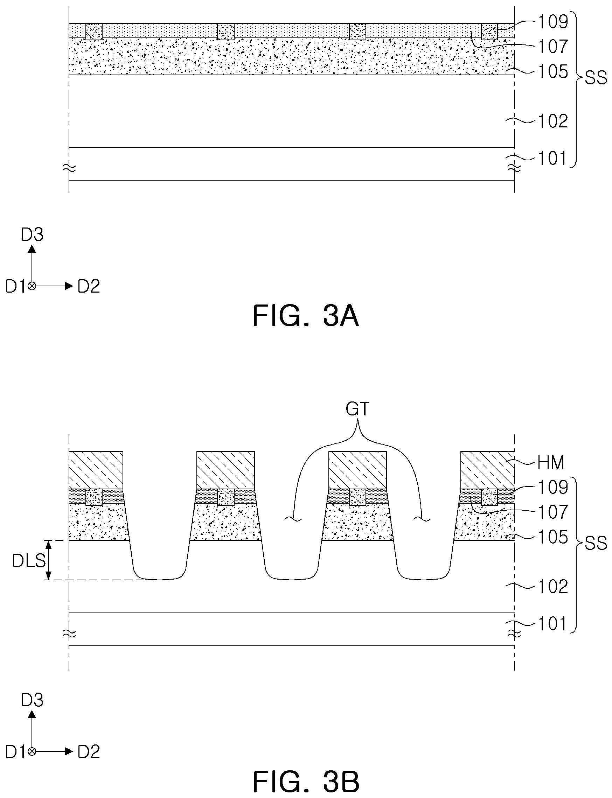

In addition, the power semiconductor device 100 may further include a gate insulating layer 120 and a gate electrode 130 disposed within gate trenches GT penetrating the source region and the well region, and a cap region 162 and a shield region 165 disposed below the gate insulating layer 120 on the bottom of the gate trenches GT. That is, the gate trenches GT may include a section DLS (see FIG. 3B) that extends into (i.e., that penetrates) the drift layer 102 but does not extend all the way through the drift layer 102. The cap region 162 and the shield region 165 may be included in the section DLS.

In one or more embodiments, the cap region 162 may be introduced into the region of the drift layer 102 below the well region 105 to reduce the resistance of the junction field effect transistor (JFET). The shield region 165 may be introduced to prevent the destruction of the gate insulating layer 120 by an electric field on the bottom of the gate trench GT. The cap region 162 and the shield region 165 may be disposed adjacent to each other below the gate insulating layer 120, on the bottom of the gate trenches GT, and this may be easily formed without introducing an additional mask. A detailed description of the arrangement, function, and process for the cap region 162 and the shield region 165.

The substrate 101 may include a semiconductor material, for example, silicon carbide (SiC). The substrate 101 is not limited thereto, and in one or more embodiments, the substrate 101 may include a group IV semiconductor material such as Si or Ge, or a compound semiconductor material such as SiGe, GaAs, InAs, or InP.

The substrate 101 may be provided as a bulk wafer or an epitaxial layer. The substrate 101 may include first conductivity-type impurities, and thus may have a first conductivity type. In one or more embodiments, the first conductivity type may be, for example, N-type, and the first conductivity-type impurities may be, for example, N-type impurities, such as nitrogen (N) and/or phosphorus (P). In one or more embodiments, the first conductivity type may be, for example, P-type, and the first conductivity-type impurities may be, for example, P-type impurities, such as aluminum (Al).

The drift layer 102 may be disposed on the substrate 101. The drift layer 102 may include a semiconductor material, for example, SiC. The drift layer 102 may be an epitaxial layer grown on the substrate 101. The drift layer 102 may include first conductivity-type impurities, and thus may have the first conductivity type. The concentration of the first conductivity-type impurities in the drift layer 102 may be lower than the concentration of the first conductivity-type impurities in the substrate 101. In one or more embodiments, the first conductivity-type impurities in the substrate 101 and the drift layer 102 may be the same or different from each other.

The well region 105 may include a semiconductor material, for example, SiC. The well region 105 may include second conductivity-type impurities, and thus may be a region having a second conductivity type. The second conductivity type may be, for example, P-type, and the second conductivity-type impurities may be, for example, P-type impurities such as aluminum (Al). In one or more embodiments, the second conductivity type may be, for example, N-type, and the second conductivity-type impurities may be, for example, N-type impurities, such as nitrogen (N) and/or phosphorus (P). The well regions 105 may be regions counter-doped to a predetermined depth by ion-implanting second conductivity-type impurities from the upper surface of the drift layer 102 of the first conductivity type. In one or more embodiments, the well region 105 may include a plurality of impurity regions having different doping concentrations.

The source region 107 may include a semiconductor material, for example, SiC. The source region 107 may be a region having the first conductivity type and may include N-type impurities such as nitrogen (N) and/or phosphorus (P), as described above. The source region 107 may be a region counter-doped to a predetermined depth by ion-implanting first conductivity-type impurities from the upper surface of the well regions 105 of the second conductivity type. In one or more embodiments, the concentration of the first conductivity-type impurities in the source region 107 may be higher than the concentration of the first conductivity-type impurities in the drift layer 102.

The well contact region 109 may include a semiconductor material, for example, SiC. The well contact region 109 may be a region having the second conductivity type and may include P-type impurities such as aluminum (Al), as described above. The well contact regions 109 may be connected (e.g. electrically connected and/or physically connected) to the well regions 105 at one side or one region of the source regions 107. The well contact regions 109 may be disposed between the well region 105 and the source electrode 150 so that a voltage from the source electrode 150 may be applied to the well region 105. The concentration of the second conductivity-type impurities in the well contact region 109 may be higher than the concentration of the second conductivity-type impurities in the well region 105.

In one or more embodiments, as illustrated in FIG. 1, the well contact region 109 may be formed to connect the well region 105 and the source electrode 150 in a part of the source region 107. The well contact region 109 may be formed deeper than the source region 107 and may extend to (e.g. into) a part of the well region 105.

As described above, in one or more embodiments, the gate insulating layer 120 and the gate electrode 130 may be disposed in the gate trenches GT.

Referring to FIG. 2A, the gate trenches GT may extend in a first direction D1 and may be arranged to be spaced apart from each other in a second direction D2 intersecting the first direction. Similarly, the source regions 107 and the well regions 105 in one or more embodiments may extend in the first direction D1 and may be arranged to be spaced apart from each other in the second direction D2. The source regions 107 and the well regions 105 may be defined by the arrangement intervals of the gate trenches GT.

The first direction D1 and the second direction D2 may be parallel to an upper surface of the substrate 101. The drift layer 102 may be located on the upper surface of the substrate 101. A third direction D3 may be perpendicular to the first direction D1 and the second direction D2 (e.g. perpendicular to the upper surface of the substrate 101). The third direction D3 may be a vertical direction. The third direction D3 may define a height direction of the semiconductor device 100. Elements that are located further along the third direction than other elements may be considered to be "above" the other elements (and, conversely, the other elements may be considered to be "below" the elements). Similarly, an "upper" section of an element may be located above a "lower" section of the element. It will be appreciated that the directions and positions defined herein and defined relative to the structure of the semiconductor device 100 and therefore need not limit the orientation of the semiconductor device 100 in use.

As illustrated in FIG. 1, the gate trenches GT may have a depth extending from the upper surfaces of the source regions 107 through the source regions 107 and well regions 105 into the drift layer 102. The gate trench GT may completely penetrate the well region 105, and the bottom of the gate trench GT may be located within the drift layer 102. The depth of the gate trench GT may be varied. In one or more embodiments, the bottom of the gate trench GT may be located on the upper surface of the drift layer 102.

The gate insulating layer 120 may be disposed on the sidewall and near a bottom surface of the gate trench GT. The gate insulating layer 120 may be disposed on portions of the source region 107 and the well region 105 exposed to the inner surface of the gate trench GT and portions of the drift layer 102. Portions of the source region 107 and the well region 105 may be exposed to the sidewall of the gate trench GT, and portions of the drift layer 102 may be exposed to the bottom of the gate trench GT and portions of the sidewall adjacent thereto.

The gate insulating layer 120 in one or more embodiments may have an uneven thickness. The gate insulating layer 120 may include a gate insulating film 121 having a first thickness formed relatively conformally along the inner surface of the gate trench GT, and a bottom insulating portion 125 disposed on the gate insulating film, near the bottom of the gate trench GT, and having a second thickness that is greater than the first thickness. Unless otherwise stated, the thickness of the gate insulating layer 120 at any particular point may be measured perpendicular to the gate insulating layer 120 (e.g. perpendicular to an upper surface of the gate insulating layer 120) at that point. An upper surface level of the bottom insulating portion 125 may be lower than a lower surface level of the well region 105 by a predetermined distance d1. The upper surface of the final bottom insulating portion 125 may define a lower surface of the gate electrode 130. The bottom insulating portion 125 may have a structure in which the thickness in the third direction D3 gradually decreases from the center of the gate trench GT to both sides (e.g. each side), below the gate electrode 130.

In this way, the gate insulating layer 120 may have a relatively large thickness on the bottom of the gate trench GT, thereby mitigating the electric field formed in the drift layer 102 by the gate electrode 130, and preventing the destruction of the gate insulating layer 120. The gate insulating layer 120 is not limited to the above-described form, and may have various shapes and thicknesses depending on the shape of the lower region of the gate trench GT.

The gate insulating layer 120 may include an oxide, a nitride, or a high-κ material. The high-κ material may refer to a dielectric material having a higher dielectric constant than silicon oxide (SiO₂). For example, the high-κ material may be any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). In one or more embodiments, the gate insulating layer 120 may be composed of two or more multilayers.

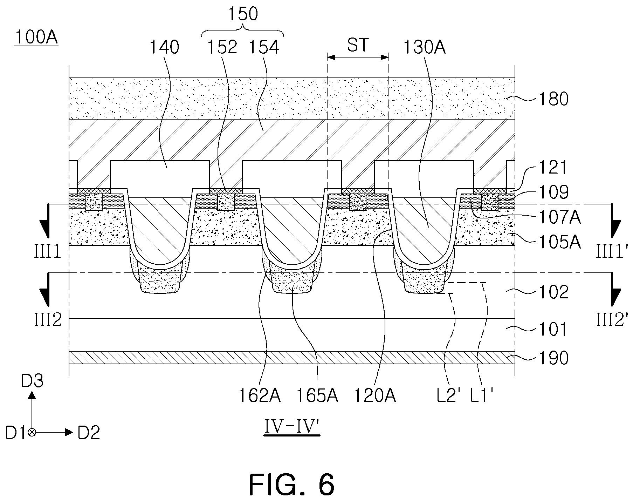

The gate electrode 130 may be disposed on the gate insulating layer 120 within the gate trench GT. As described above, the lower surface of the gate electrode 130 may be positioned on a lower level than the lower surface of the well region 105. The gate electrode 130 may overlap a portion of the drift layer 102, the well region 105, and the source region 107 in a direction D2 (e.g. the second direction) parallel to the upper surface of the substrate 101. A portion of the gate electrode 130 may be positioned within the drift layer 102. The gate electrode 130 may have an upper surface that is lower than the upper surface level of the source region 107 by a predetermined distance d2. The present inventive concept is not limited thereto, and in one or more embodiments, the level of the upper surface of the gate electrode (130A in FIG. 6) may be positioned at the same level as or higher than the upper surface of the source region 107.

The gate electrode 130 may include a conductive material, for example, a semiconductor material such as doped polycrystalline silicon, a metal nitride such as titanium nitride (TiN), tantalum nitride (TaN), or tungsten nitride (WN), and/or a metal material such as aluminum (Al), tungsten (W), or molybdenum (Mo). In one or more embodiments, the gate electrode 130 may be composed of two or more multilayers.

The power semiconductor device 100 may have a metal-oxide-semiconductor field effect transistor (MOSFET) structure. Having said this, in use a JFET (e.g. a parasitic JFET) may be formed. This may be formed at between adjacent well regions 105, with a channel formed in the drift layer 102. As such, the power semiconductor device 100 according to one or more embodiments may have a JFET structure, configured such that current flows through a channel between the drift layer 102 and the well region 105. The resistance of this channel is referred to as the JFET resistance, which is related to the electrical characteristics of the device. In detail, the JFET resistance may have a significant effect on the power semiconductor device 100 when a large amount of current flows.

In one or more embodiments, the cap region 162 may be an impurity region disposed in the region of the drift layer 102 adjacent to the well region 105, which may increase the carrier concentration of the channel and reduce the JFET resistance. The cap region 162 may have the same conductivity type as the conductivity type of the drift layer 102. In one or more embodiments, the cap region 162 may have a first conductivity type and may include first conductivity-type impurities. The first conductivity-type impurities may be, for example, N-type impurities such as nitrogen (N) and/or phosphorus (P).

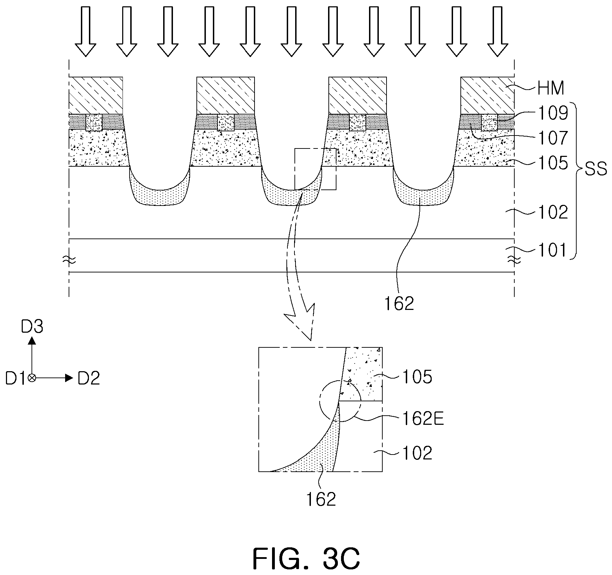

Referring to FIG. 1, the cap region 162 may be disposed in the region of the drift layer 102 (e.g., DLS of FIG. 3B) below the gate insulating layer 120 on the bottom of the gate trench GT, and may have an edge portion 162E (see FIG. 3C) extending along the bottom of the gate trench GT toward the well region 105. In one or more embodiments, the edge portion 162E may be connected to the well region 105. In this way, the cap region 162 may reduce the JFET resistance by providing a region of a high concentration first conductivity type in the region of the drift layer 102 adjacent to the well region 105. This resistance reduction may contribute to improving the efficiency of the device by lowering the on-resistance of the device and reducing power loss.

The cap region 162 of the first conductivity type may be formed by ion-implanting a first conductivity-type impurity into the region of the drift layer 102 exposed to the bottom of the gate trench GT. To increase the electron concentration of the channel, the cap region 162 may have a higher concentration of the first conductivity-type impurity than the concentration of the first conductivity-type impurity of the drift layer 102. To prevent counter-doping of the well region 105 during the formation process of the cap region 162, the cap region 162 may have a concentration of first conductivity-type impurities that is lower than the concentration of second conductivity-type impurities in the well region 105. In one or more embodiments, the concentration of the first conductivity-type impurities in the cap region 162 may be lower than the concentration of the first conductivity-type impurities in the source region 107.

As illustrated in FIG. 1, the shield region 165 may be disposed in the region of the drift layer 102 below the gate insulating layer 120 on the cap region 162. In one or more embodiments, the shield region 165 may have an upper surface that contacts the gate insulating layer 120. In one or more embodiments, the shield region 165 of the second conductivity located below the gate insulating layer 120 may effectively disperse an electric field applied to the gate insulating layer 120 when a high voltage (for example, a reverse voltage) is applied, thereby preventing the destruction of the gate insulating layer 120.

The shield region 165 may have a conductivity type opposite to that of the drift layer 102. In one or more embodiments, the shield region 165 may have a second conductivity type and may include second conductivity-type impurities. The second conductivity-type impurities may be, for example, P-type impurities such as aluminum (Al).

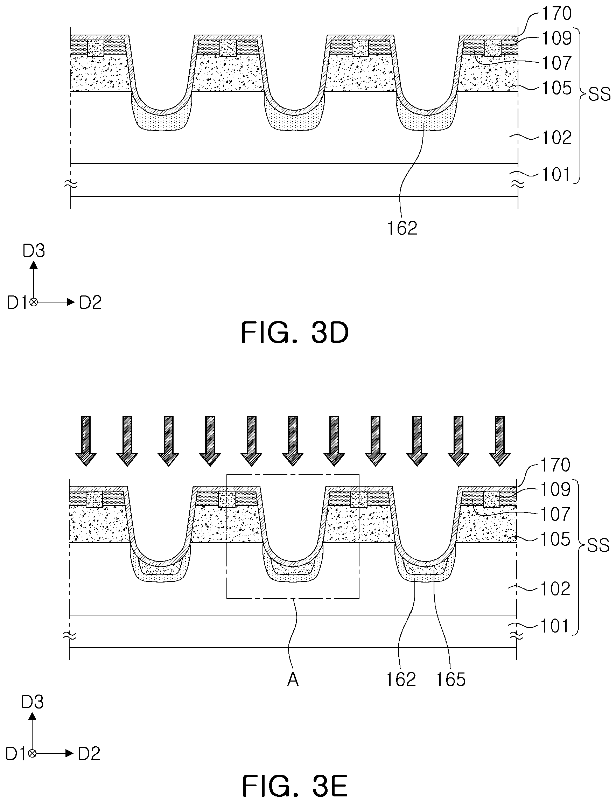

The shield region 165 may be a region counter-doped to a predetermined depth by ion-injecting second conductivity-type impurities from the upper surface of the first-conductivity cap region 162 (see FIG. 3E). For this counter-doping, the shield region 165 may have a concentration of second conductivity-type impurities higher than the concentration of first conductivity-type impurities in the cap region 162. To prevent counter-doping of the source region 107 during the formation process of the shield region 165, the shield region 165 may have a concentration of second conductivity-type impurities lower than the concentration of first conductivity-type impurities in the source region 107. In one or more embodiments, the concentration of second conductivity-type impurities in the shield region 165 may be lower than the concentration of second conductivity-type impurities in the well region 105.

As described above, the shield region 165 may be disposed within the cap region 162 by counter-doping. As illustrated in FIG. 1, the width W2 of the shield region 165 in the second direction D2 may be smaller than the width W1 of the cap region 162 in the second direction D2. The cap region 162 may be disposed on a side of the shield region 165 adjacent to the well region 105 in the region (e.g., DSL of FIG. 3B) of the drift layer 102. In one or more embodiments, the cap region 162 may extend to cover the bottom of the shield region 165. The lower surface level L1 of the cap region 162 may be lower than the lower surface level L2 of the shield region 165 (as shown in FIG. 1). Alternatively, the lower surface level L1 of the cap region 162 may be higher than the lower surface level L2 of the shield region 165 (as shown in FIG. 6). This structure may be determined according to the ion implantation depths of the cap region 162 and the shield region 165, and for example, may be obtained by setting the ion implantation depth of the shield region 165 to be lower than the ion implantation depth of the cap region 162.

Referring to FIG. 2A, the gate trenches GT and the gate electrodes 130 extend in the first direction D1, and similarly, referring to FIG. 2B, the shield region 165 may also extend in the first direction D1. In this case, the cap region 162 may be disposed on both sides of the shield region 165 in the second direction D2 and may extend in the first direction D1.

Interlayer insulating layers 140 may cover the gate electrodes 130 and may be positioned to expose at least a portion of each of the source regions 107 and the well contact regions 109. The interlayer insulating layers 140 may cover a side surface of the gate electrode 130 and a side surface of the gate insulating layer 120. The interlayer insulating layers 140 may include an insulating material, and may include at least one of silicon oxide, silicon nitride, and silicon oxynitride. In one or more embodiments, the interlayer insulating layers 140 may also include a high-κ material.

The source electrode 150 may be disposed on the interlayer insulating layers 140 and may be electrically connected to the source regions 107 and the well contact regions 109. The source electrode 150 may include a metal-semiconductor compound layer 152 disposed at an interface contacting the source regions 107 and the well contact regions 109, and a conductive layer 154 on the metal-semiconductor compound layer 152. The metal-semiconductor compound layer 152 may include a metal element and a semiconductor element, and may include at least one of, for example, TiSi, CoSi, MoSi, LaSi, NiSi, TaSi, or Wsi. The conductive layer 154 may include a metal material, for example, at least one of nickel (Ni), aluminum (Al), titanium (Ti), silver (Ag), vanadium (V), tungsten (W), cobalt (Co), molybdenum (Mo), copper (Cu), and ruthenium (Ru).

A drain electrode 190 may be disposed on the lower surface of the substrate 101 and may be electrically connected to the substrate 101. The drain electrode 190 may include a metal material, for example, at least one of nickel (Ni), aluminum (Al), titanium (Ti), silver (Ag), vanadium (V), and tungsten (W). In one or more embodiments, the drain electrode 190 may also include a metal-semiconductor compound layer similar to the source electrode 150.

A passivation layer 180 may be sequentially stacked on the source electrode 150. The passivation layer 180 may include an insulating material. For example, the passivation layer 180 may include at least one inorganic material among silicon oxide, silicon nitride, and silicon oxynitride, and/or an organic material such as photosensitive polyimide (PSPI).

The power semiconductor device 100 is described as an example of a metal-oxide-semiconductor FET (MOSFET), but the gate insulating layer 120 may also be applied to a super junction MOSFET, a double trench MOSFET, an Insulated Gate Bipolar Transistor (IGBT) device, and the like. For example, when the power semiconductor device is an IGBT, the substrate 101 may have the second conductivity type.

FIG. 3A to FIG. 3E are cross-sectional views illustrating a method of manufacturing a power semiconductor device illustrated in FIGS. 2A and 2B according to one or more embodiments.

First, referring to FIG. 3A, a substrate structure SS having a substrate 101 of a first conductivity type, a drift layer 102 of the first conductivity type on the substrate 101, a well region 105 of a second conductivity type on the drift layer 102, and a source region 107 of the first conductivity type on the well region 105 may be formed.

The substrate 101 may be provided as, for example, a SiC wafer of the first conductivity type (for example, N-type). The drift layer 102 may be formed by growing an epitaxial layer of the first conductivity type on the substrate 101. In one or more embodiments, each of the well region 105 and the source region 107 may be formed in a layer structure by an ion implantation process from the upper surface of the drift layer 102. In detail, the well region 105 may be formed by counter-doping a second conductivity-type impurity using an ion implantation process to a first depth from the upper surface of the drift layer 102. Then, the source region 107 may be formed by counter-doping a first conductivity-type impurity using an ion implantation process to a second depth that is less than the first depth from the upper surface of the well region 105. Next, well contact regions 109 connected to the well region 105 may be formed by counter-doping a second conductivity-type impurity using an ion implantation process to some regions of the source region 107 at regular intervals (for example, see FIG. 2A).

Next, referring to FIG. 3B, a gate trench GT may be formed in a substrate structure SS using a mask HM.

The gate trenches GT may be formed by partially removing the source region 107, the well region 105, and the drift layer 102 after forming the mask HM. The masks HM each have patterns extending in a first direction D1 and are spaced apart from each other in a second direction D2, and the gate trenches GT may be defined by an open area of the mask HM (see FIG. 2A). The mask HM may include a hard mask or a photoresist.

In one or more embodiments, the gate trenches GT are formed by penetrating the well region 105, and a region of the drift layer 102 may be opened on the bottom of the gate trenches GT. In one or more embodiments, the gate trenches GT may be formed to a depth extending to a portion of the drift layer 102.

Next, referring to FIG. 3C, a cap region 162 of a first conductivity type may be formed by ion-implanting a first conductivity-type impurity into the open area of the drift layer 102 using the mask HM.

By using the mask HM used in the previous process as it is, a cap region 162 of the first conductivity type may be formed in the region of the drift layer 102 that is open on the bottom of the gate trench GT. The cap region 162 of the first conductivity type may be formed to have an edge portion 162E connected to the second conductivity type well region 105. The edge portion 162E may extend along the bottom of the gate trench GT to the second conductivity type well region 105. In one or more embodiments, since the sidewall of the gate trench GT is slightly inclined even though it is nearly vertical, the cap region 162 of the first conductivity type may be stably connected to the well region 105 of the second conductivity type at the sidewall portion adjacent to the bottom of the gate trench GT.

In one or more embodiments, the cap region 162 of the first conductivity type may not be connected to the well region 105 of the second conductivity type even though it extends along the bottom of the gate trench GT along the well region 105 of the second conductivity type. Even in this case, if the gap between the cap region 162 of the first conductivity type and the well region 105 of the second conductivity type is sufficiently small, the effect of reducing the JFET resistance is still achieved. For example, the gap between the cap region 162 of the first conductivity type and the well region 105 of the second conductivity type may be 10 nm or less.

As described above, the concentration of the first conductivity-type impurity in the cap region 162 may be greater than the concentration of the first conductivity-type impurity in the drift layer 102 to increase the electron concentration of the channel. Also, the concentration of the first conductivity-type impurity in the cap region 162 may be less than the concentration of the second conductivity-type impurity in the well region 105 to prevent undesired counter-doping of the well region 105. In one or more embodiments, the concentration of the first conductivity-type impurity in the cap region 162 may be less than the concentration of the first conductivity-type impurity in the source region 107.

Next, referring to FIG. 3D, after removing the mask HM, a thermal oxidation film 170 (otherwise known as a thermal oxide film) may be formed on the surface of the substrate structure SS on which the gate trench GT is formed. The thermal oxidation film 170 (or thermal oxide film) may be an oxide film formed through thermal oxidation. For instance, where the substrate structure SS comprises SiC, the thermal oxidation film 170 may comprise silicon oxide (e.g. SiO₂).

In this process, the thermal oxidation film 170 may be formed on the exposed surface of the substrate structure SS by a thermal oxidation process. The thermal oxidation film 170 may be formed on the exposed inner surface of the gate trench GT and the upper surfaces of the source region 107 and the well contact region 109.

In the case where the substrate structure SS in one or more embodiments is SiC-based, the thermal oxidation process may be performed at a high temperature. For example, the thermal oxidation film 170 formation process may be performed at a temperature above 1300°C (e.g. a temperature of 1300°C to 1900°C). In addition, the thermal oxidation film 170 formed in one or more embodiments may be formed with an appropriate thickness to perform a mask function for selective ion implantation in the formation process of the shield region 165. Although not limited thereto, the thermal oxidation film 170 may be formed with a thickness of, for example, 100 nm or less.

Next, referring to FIG. 3E, the thermal oxidation film 170 may be used to form a shield region 165 of the second conductivity type by ion implanting a second conductivity-type impurity into a portion of the cap region 162 of the first conductivity type.

In the present process, the previously formed thermal oxidation film 170 may be used as a mask for selective ion implantation. Since the second conductivity-type impurity ions are implanted in the third direction D3 perpendicular to the upper surface of the substrate 101, the ions may be selectively implanted depending on the thickness of the thermal oxidation film 170 in the third direction D3.

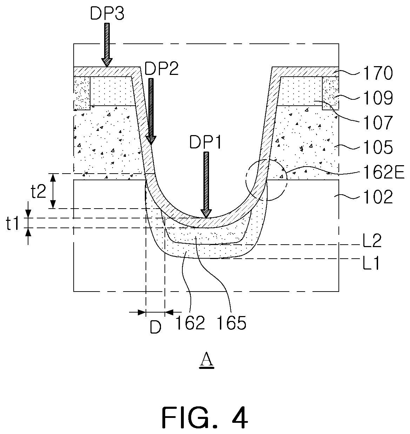

FIG. 4 is a partially enlarged view illustrating area A of FIG. 3E according to one or more embodiments.

Referring to FIG. 4, the thermal oxidation film 170 may have a relatively small first thickness t1 (e.g. in the third direction D3) near the bottom of the gate trench GT and an adjacent side thereof, while having a relatively large second thickness t2 (e.g. in the third direction D3) at the sidewall of the gate trench GT. Under predetermined ion implantation conditions, the ion implantation DP1 may be permitted in a portion of the thermal oxidation film 170 having the first thickness t1, while the ion implantation DP2 may be blocked in a portion of the thermal oxidation film 170 having the second thickness t2. Even if the ions DP3 implanted into the portion of the thermal oxidation film 170 on the source region 107 are implanted into the source region 107, since the concentration of the first conductivity-type impurity of the source region 107 is greater than the concentration of the first conductivity-type impurity injected to form the cap region 162, the ions DP3 may not have a significant effect on the characteristics of the source region 107.

Therefore, while forming a shield region 165 of the second conductivity type within the cap region 162 of the first conductivity type on the bottom of the gate trench GT, both sides of the cap region 162 of the first conductivity type may remain with a constant width D on the sidewall of the gate trench GT.

The cap region 162 of the first conductivity type remaining after this process is a portion adjacent to the well region 105 that may contribute to an increase in the electron concentration of the channel, thereby effectively performing the function of reducing the JFET resistance. In one or more embodiments, the cap region 162 of the first conductivity type remaining may be located on both sides of the shield region 165 of the second conductivity type in the second direction D2.

In this way, in this process, the thermal oxide film 170 may be used as a mask for selective ion implantation, and a shield region 165 may be formed in a desired width within the cap region 162 without an additional mask process.

By controlling the ion implantation depth of the second conductivity-type impurity in this process, the lower surface level L1 of the cap region 162 may be set lower or higher than the lower surface level L2 of the shield region 165. In addition, after the ion implantation process, a high temperature (for example, about 1500°C to about 1900°C) annealing process may be performed to activate the impurity regions.

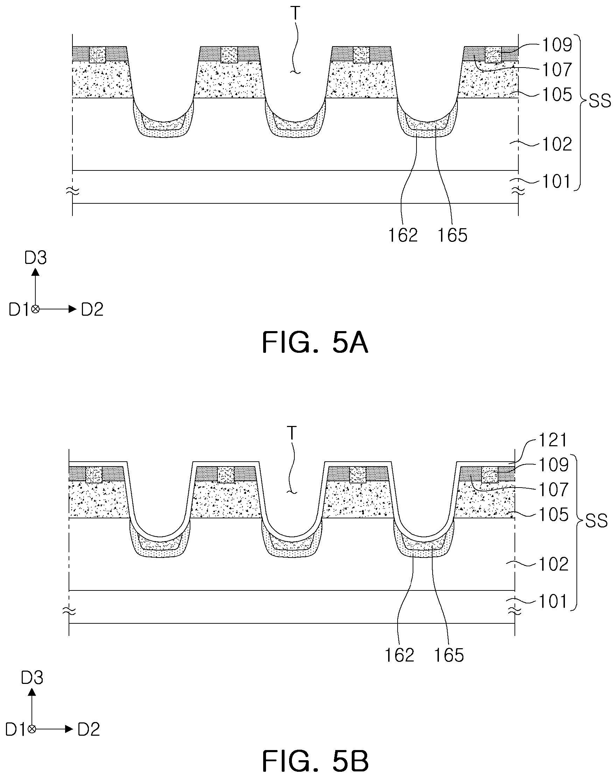

FIG. 5A to FIG. 5E are cross-sectional views illustrating a method of manufacturing a power semiconductor device according to one or more embodiments.

Referring to FIG. 5A, the thermal oxide film 170 previously used as a mask is removed, and referring to FIG. 5B, a gate insulating film 121 may be formed on the surface of the substrate structure SS.

In this manner, the thermal oxide film 170 significantly damaged in the ion implantation process is removed, and the gate insulating film 121 may be formed. After removing the thermal oxide film 170 and before forming the gate insulating film 121, an annealing process may be performed for surface treatment. For example, a hydrogen (H₂) annealing process and a high-temperature annealing process performed in a hydrogen (H₂) atmosphere may be included. The gate insulating film 121 may be conformally formed, for example, by an oxidation process (for example, a thermal oxidation process) or a deposition process.

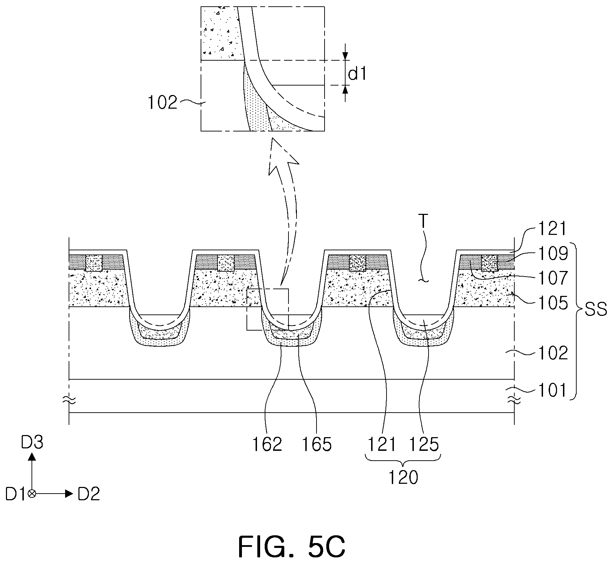

Then, referring to FIG. 5C, a gate insulating layer 120 for one or more embodiments may be formed by forming a bottom insulating portion 125 on the bottom of a gate trench GT.

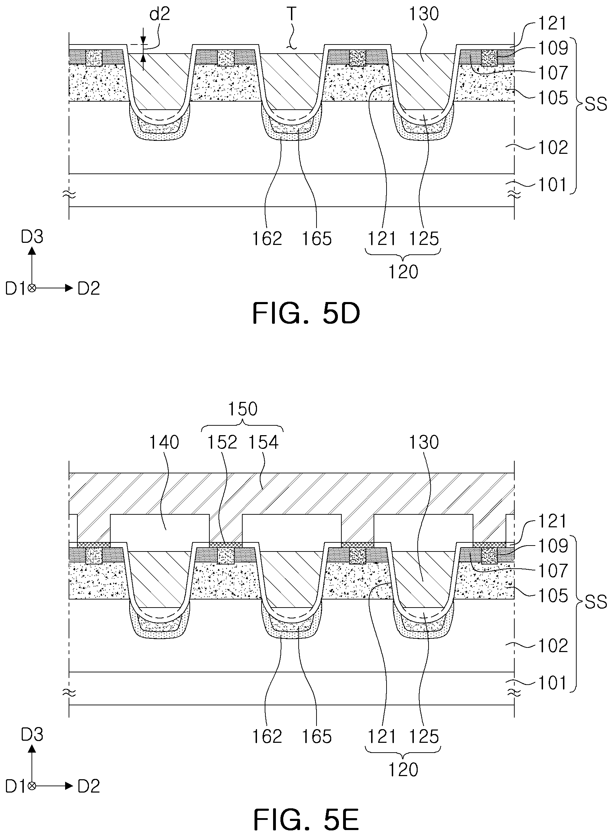

An insulating material may be additionally formed within the trench region T. The insulating material for the bottom insulating portion 125 may be formed, for example, by a Spin-On Glass (SOG) process or a High Temperature Oxide (HTO) process. Then, the insulating material may be etched back to form a bottom insulating portion 125 having a controlled upper surface level. By the etch-back process, the bottom insulating portion 125 may have an upper surface at a level lower than the lower surface level of the well region 105 by a predetermined distance d1. The upper surface of the final bottom insulating portion 125 may define the lower surface of the gate electrode (130 in FIG. 5D). In this etch-back process, portions of the gate insulating film 121 on the source region 107 may also be removed. In one or more embodiments (for example, see FIG. 6), this process may be omitted.

Next, referring to FIG. 5D, a gate electrode 130 may be formed within a gate trench GT in which a gate insulating layer 120 is formed.

The gate electrode 130 may be formed, for example, by depositing doped polycrystalline silicon and performing an etch-back process. The gate electrode 130 may be formed to be located only within the trench region T. In one or more embodiments, the gate electrode 130 may have an upper surface that is lower than the upper surface level of the source region 107 by a predetermined distance d2 due to the etch-back process. However, embodiments are not limited thereto, and in one or more embodiments, the upper surface of the gate electrode 130 may have a level higher than the upper surface level of the well region 105.

Next, referring to FIG. 5E, after forming an interlayer insulating layer 140 covering the gate electrode 130, an opening in which the source region 107 opens (e.g. is exposed) may be formed. Next, metal-semiconductor compound layers 152 may be formed, and electrode conductive layer 154 may be formed on the metal-semiconductor compound layers 152.

After forming the interlayer insulating layer 140, an opening that opens (e.g. exposed) a portion of the source regions 107 and the well contact region 109 may be formed in the interlayer insulating layer 140. In one or more embodiments, when a gate insulating film 121 remains on the source regions 107, the remaining gate insulating film 121 may be patterned together during the patterning process of the interlayer insulating layer 140. A source electrode may be formed by forming metal-semiconductor compound layers 152 on the open (e.g. exposed) portions of the source regions 107 and the well contact region 109, and forming the conductive layer 154 to be connected to the metal-semiconductor compound layers 152. The metal-semiconductor compound layers 152 may be formed by, for example, a silicidation process. In one or more embodiments, the conductive layer 154 may be formed to cover the interlayer insulating layer 140.

Next, a drain electrode 190 may be formed on the lower surface of the substrate 101. In detail, a metal material may be deposited on the lower surface of the substrate 101 to form the drain electrode 190, and a passivation layer 180 may be formed on the source electrode 150. In one or more embodiments, the drain electrode 190 may be formed in another process step. Through these processes, the power semiconductor device 100 illustrated in FIG. 1 may be manufactured.

One or more embodiments may be implemented as a power semiconductor device having various structures that introduce a gate trench. For example, in a planar view, the cell stacks of the source region and the well region may be arranged to be spaced apart from each other, and the cap region and the shield region according to one or more embodiments may be introduced as the lower structure of the gate trench defining the cell stacks. These embodiments are illustrated in FIGS. 6 to 9.

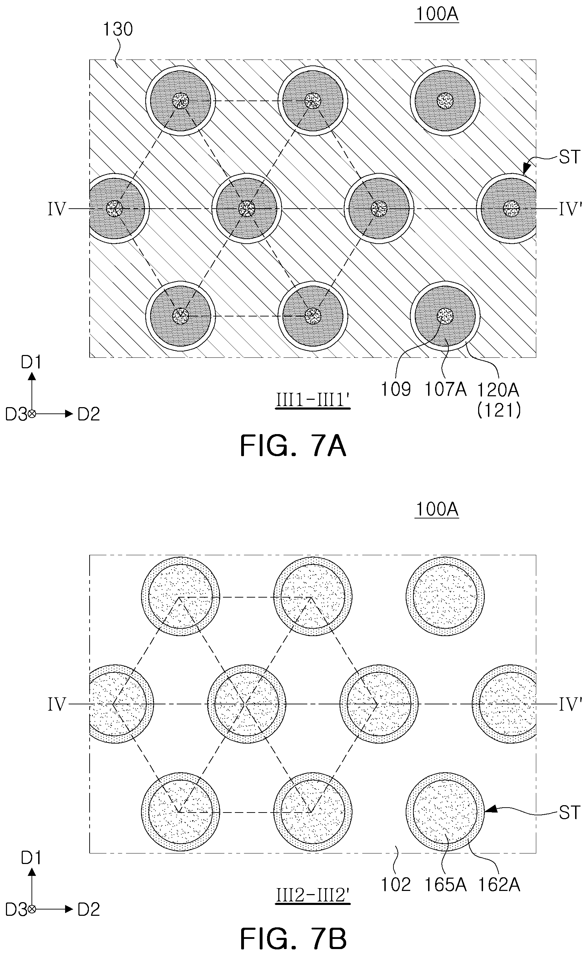

FIG. 6 is a cross-sectional view illustrating a power semiconductor device according to one or more embodiments. FIG. 7A and FIG. 7B are plan views illustrating the power semiconductor device illustrated in FIG. 6, taken along lines III1-III1' and III2-III2', according to one or more embodiments.

Referring to FIG. 6 and FIG. 7A and FIG. 7B, a power semiconductor device 100A according to one or more embodiments may be understood as being similar to the power semiconductor device 100 illustrated in FIG. 1 and FIG. 2A and FIG. 2B, except that the cell stacks ST of the source region 107A and the well region 105A may be arranged spaced apart from each other in a planar view, a shield region 165A may be formed deeper than the cap region 162A, and the gate insulating layer 120A having a relatively constant thickness may be included. In addition, the components of one or more embodiments may be understood by referring to the description of the same or similar components of the power semiconductor device 100 illustrated in FIG. 1 and FIG. 2a and FIG. 2B, unless otherwise specifically described.

The gate trench GT in one or more embodiments may be respectively formed to define a plurality of stacks ST having a source region 107A of a first conductivity type and a well region 105A of a second conductivity type. The bottom of the gate trench GT may be provided by the drift layer 102. In one or more embodiments, the gate trench GT may be formed to a depth extending from the source region 107A and the well region 105A to a portion of the drift layer 102 of the first conductivity type. The stacks ST employed in one or more embodiments may further include an upper region of the drift layer 102.

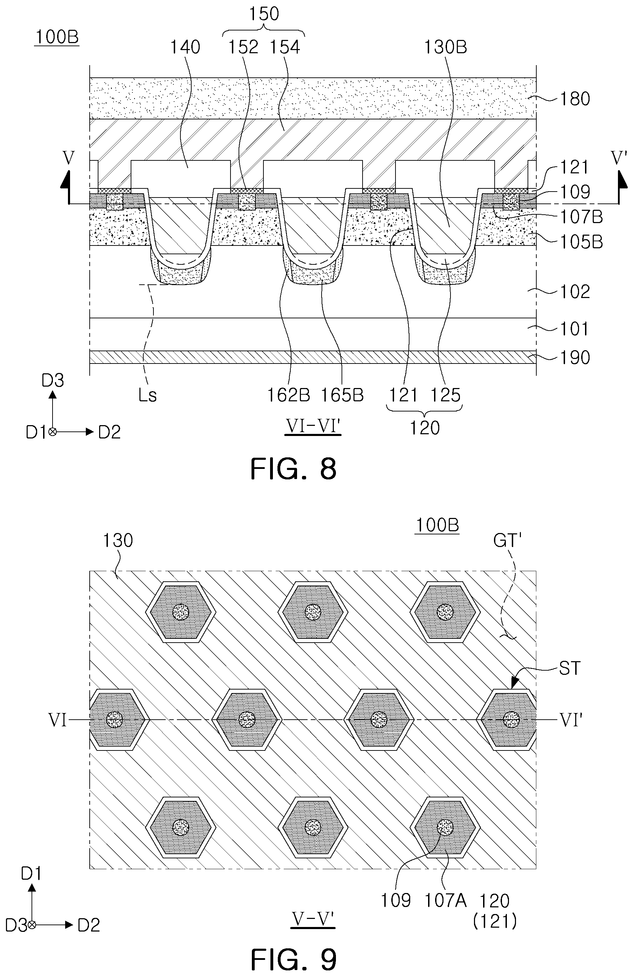

Referring to FIGS. 7A and 7B, in one or more embodiments, the cell stacks ST may have a cylindrical structure with rounded sides, but are not limited thereto, and in one or more embodiments, the cell stacks ST may have a hexagonal cylindrical structure (see FIG. 9). That is, the stacks ST may have one of a variety of different cross-sectional shapes. A plurality of cell stacks ST may be arranged at regular intervals in the first and second directions D1 and D2 from a planar viewpoint. In one or more embodiments, the plurality of cell stacks ST may be arranged in a hexagonal shape.

The power semiconductor device 100A according to one or more embodiments may further include a gate electrode 130A surrounding the cell stacks ST and filled between the cell stacks ST, and a gate insulating layer 120A disposed between the cell stacks ST and the gate electrode 130A. In this manner, the gate trench GT may be provided as a space in which the gate structure, for example, the gate insulating layer 120A and the gate electrode 130A are disposed.

The power semiconductor device 100A according to one or more embodiments may further include the cap region 162A of a first conductivity type and the shield region 165A of a second conductivity type disposed below the gate insulating layer 120A, on the bottom of the gate trench GT.

In one or more embodiments, the cap region 162A of the first conductivity type may be disposed in the region of the drift layer 102 below the gate insulating layer 120A, and may have an edge portion extending toward the well region 105A of each of the plurality of cell stacks ST. In one or more embodiments, the edge portion may be connected to the well region 105A. In this way, the cap region 162A may reduce the JFET resistance by providing a high-concentration first conductivity type region in the region of the drift layer 102 adjacent to the well region 105A.

The shield region 165A of the second conductivity type may be disposed in the region of the drift layer 102 below the gate insulating layer 120A on the bottom of the gate trench GT. In one or more embodiments, the shield region 165A may have an upper surface that contacts the gate insulating layer 120A. The shield region 165A may prevent the destruction of the gate insulating layer 120 by an electric field.

In one or more embodiments, as illustrated in FIG. 7B, the cap region 162A may be disposed on the side of the shield region 165A adjacent to the well region 105A of each cell stack ST, in the region of the drift layer 102. For example, the cap region 162A may be disposed to surround a portion of the shield region 165A of respective cell stacks ST.

In one or more embodiments, the lower surface level L2' of the shield region 165A may be positioned lower than the lower surface level L1' of the cap region 162A. This structure may be formed by setting the ion implantation depth of the shield region 165A deeper than the ion implantation depth of the cap region 162A. In this manner, the shield region 165A with a relatively large thickness may more stably prevent the destruction of the gate insulating layer 120A due to an electric field. Therefore, the gate insulating layer 120A introduced in one or more embodiments may be formed with a relatively constant thickness without a bottom insulating portion.

FIG. 8 is a cross-sectional view of a power semiconductor device according to one or more embodiments. FIG. 9 is a plan view of a power semiconductor device according to one or more embodiments.

Referring to FIGS. 8 and 9, a power semiconductor device 100B according to one or more embodiments may be understood as being similar to the power semiconductor device 100 illustrated in FIGS. 1, 2A, and 2B, except that the cell stacks ST' of the source region 107B and the well region 105B may be arranged spaced apart from each other in a planar view and the shield region 165B and the cap region 162B may be formed to have almost the same depth. In addition, the components of one or more embodiments may be understood by referring to the description of the same or similar components of the power semiconductor device 100 illustrated in FIGS. 1, 2A, and 2B, unless otherwise specifically described.

The gate trench in one or more embodiments may be respectively formed to define a plurality of stacks ST' having a source region 107B of a first conductivity type and a well region 105B of a second conductivity type. The bottom of the gate trench GT' may be provided by the drift layer 102. In one or more embodiments, the gate trench GT' may be formed to a depth that extends from the source region 107B and the well region 105B to a portion of the drift layer 102 of the first conductivity type. The stacks ST' in one or more embodiments may further include an upper region of the drift layer 102.

Referring to FIG. 9, in one or more embodiments, the cell stacks ST' may have a hexagonal columnar structure in a planar view and may be arranged in a hexagonal shape.

The power semiconductor device 100B according to one or more embodiments may further include a gate electrode 130B surrounding the cell stacks ST' and filled between the cell stacks ST', and a gate insulating layer 120 disposed between the cell stacks ST' and the gate electrode 130B.

The power semiconductor device 100B according to one or more embodiments may further include a cap region 162B of the first conductivity type and a shield region 165B of the second conductivity type disposed below the gate insulating layer 120, on the bottom of the gate trench GT'.

In one or more embodiments, the cap region 162B of the first conductivity type may be disposed in the region of the drift layer 102 below the gate insulating layer 120, on the bottom of the gate trench GT', and may have an edge portion extending along the bottom of the gate trench GT' toward the well region 105B of each of the plurality of cell stacks ST'. In one or more embodiments, the edge portion may be connected to the well region 105B. In this way, the cap region 162B may reduce the JFET resistance by providing a region of the drift layer 102 with a high concentration of the first conductivity type adjacent to the well region 105B.

The shield region 165B of the second conductivity type may be disposed in the region of the drift layer 102 below the gate insulating layer 120 on the bottom of the gate trench GT'. In one or more embodiments, the shield region 165B may have an upper surface that contacts the gate insulating layer 120. The shield region 165B may prevent the gate insulating layer 120 from being destroyed by an electric field.

The cap region 162B in one or more embodiments may be disposed on the side of the shield region 165B adjacent to the well region 105B of each cell stack ST', in the region of the drift layer 102, and may surround a portion of the drift layer 102 of respective cell stacks ST.

In one or more embodiments, the lower surface of the shield region 165B and the lower surface of the cap region 162B may be located at the same level Ls (e.g. almost the same level Ls). This structure may be formed by setting the ion implantation depth of the shield region 165B to be the same (e.g. almost the same) as the ion implantation depth of the cap region 162B. In this way, the relative depths of the shield region 165B and the cap region 162B may be varied.

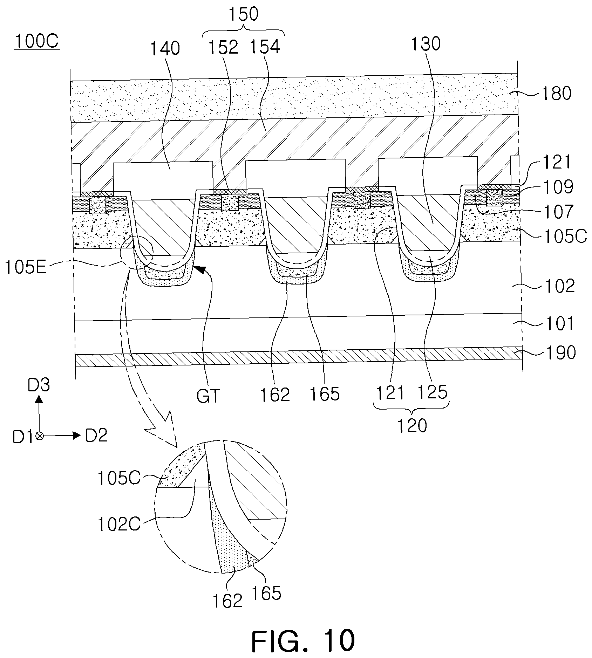

FIG. 10 is a cross-sectional view of a power semiconductor device according to one or more embodiments.

Referring to FIG. 10, a power semiconductor device 100C according to one or more embodiments may be understood as being similar to the power semiconductor device 100 illustrated in FIG. 1, FIG. 2A, and FIG. 2B, except that the shape of the well region 105C may be different and the well region 105C and the cap region 162 may not be directly connected. In addition, the components of one or more embodiments may be understood by referring to the description of the same or similar components of the power semiconductor device 100 illustrated in FIG. 1, FIG. 2A, and FIG. 2B, unless otherwise specifically described.

The second conductivity type well region 105C may have a chamfered portion 105E in the lower region adjacent to the gate trench GT. Even though the first conductivity type cap region 162 extends along the bottom of the gate trench GT toward the well region 105C in the region of the drift layer 102 below the gate insulating layer 120, the first conductivity type cap region 162 may not be directly connected to (e.g. may not directly contact) the well region 105C. This chamfered portion 105E may be a structure obtained by counter-doping a portion of the lower region 102C of the well region 105C according to the slope of the sidewall of the gate trench GT in the process of forming the cap region 162 by injecting the first conductivity-type impurity.

In one or more embodiments, when the gap between the cap region 162 and the well region 105 is sufficiently small, an effect of reducing the JFET resistance may be expected. For example, the gap between the cap region 162 and the well region 105C may be 10 nm or less.

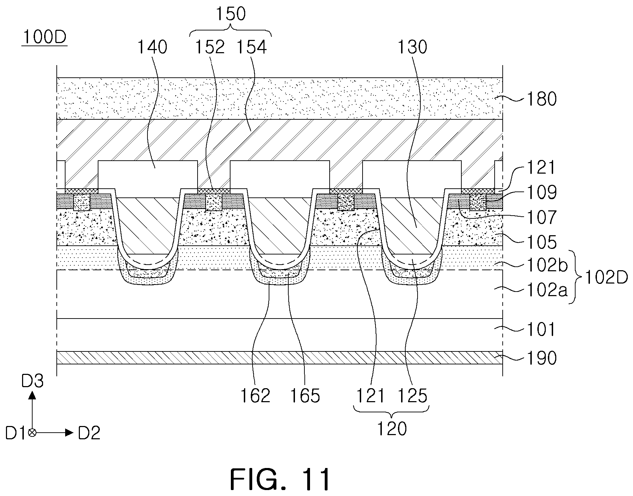

FIG. 11 is a cross-sectional view of a power semiconductor device according to one or more embodiments.

Referring to FIG. 11, a power semiconductor device 100D according to one or more embodiments may be understood as being similar to the power semiconductor device 100 illustrated in FIGS. 1 and 2a and 2b, except that the drift layer 102D may include a low-concentration layer 102a and a high-concentration layer 102b, and that the interface between the low-concentration layer 102a and the high-concentration layer 102b may overlap the cap region 162 and the shield region 165. In addition, the components of one or more embodiments may be understood by referring to the description of the same or similar components of the power semiconductor device 100 illustrated in FIGS. 1 and 2A and 2B, unless otherwise specifically described.

The drift layer 102D in one or more embodiments may include a low-concentration layer 102a and a high-concentration layer 102b on the low-concentration layer 102a. The concentration of first conductivity-type impurities in the low-concentration layer 102a may be less than the concentration of first conductivity-type impurities in the high concentration layer 102b. The high-concentration layer 102b may be a current dissipation region and may be disposed adjacent to the well region 105 while overlapping the upper portion of the cap region 162. The high-concentration layer 102b may reduce the JFET resistance in the region adjacent to the well region 105 together with the cap region 162 of the second conductivity, thereby lowering the on-resistance. In addition, in one or more embodiments, the low-concentration layer 102a may be disposed to overlap the lower portion of the shield region 165, thereby more effectively preventing the destruction of the gate insulating layer 120.

In this way, in one or more embodiments, the drift layer 102D is composed of a low-concentration layer 102a and a high-concentration layer 102b, and the interface is designed to overlap with the cap region 162 and the shield region 165, thereby improving the electrical characteristics more effectively.

As set forth above, according to the embodiments described above, a cap region of a first conductivity type for reducing a resistance component of JFET and a shield region of a second conductivity type for preventing destruction of a gate insulating layer due to reverse voltage may be formed together below a trench region. This composite structure may be formed by a self-alignment method using a thermal oxide film, without introducing an additional mask.

Each of the embodiments provided in the above description is not excluded from being associated with one or more features of another example or another embodiment also provided herein or not provided herein but consistent with the disclosure.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

Embodiments are set out in the following Clauses:
Clause 1. A semiconductor device comprising:
   a silicon carbide (SiC) substrate of a first conductivity type;
   a drift layer of the first conductivity type on the SiC substrate;
   a well region of a second conductivity type on the drift layer;
   a source region of the first conductivity type on the well region;
   a gate trench extending through the source region and the well region, and extending into the drift layer;
   a gate insulating layer in the gate trench;
   a gate electrode on the gate insulating layer;
   a cap region of the first conductivity type below the gate insulating layer and in a section of the gate trench that extends into the drift layer, the cap region comprising an edge portion extending toward the well region;
   a shield region of the second conductivity type within the cap region, below the gate insulating layer and contacting the gate insulating layer;
   a source electrode connected to the source region; and
   a drain electrode on a lower surface of the SiC substrate.
Clause 2. The semiconductor device of Clause 1, wherein the gate trench and the shield region extend in a first direction in which an upper surface of the SiC substrate extends, and
   wherein the cap region is on side surfaces of the shield region in a second direction intersecting the first direction.
Clause 3. The semiconductor device of Clause 2, wherein a width of the shield region in the second direction is smaller than a width of the cap region in the second direction.
Clause 4. The semiconductor device of any preceding Clause, wherein a concentration of a first conductivity-type impurity in the cap region is greater than a concentration of the first conductivity-type impurity in the drift layer, and smaller than a concentration of a second conductivity-type impurity in the well region.
Clause 5. The semiconductor device of any preceding Clause, wherein a concentration of a second conductivity-type impurity in the shield region is greater than a concentration of a first conductivity-type impurity in the cap region and less than a concentration of the first conductivity-type impurity in the source region.
Clause 6. A semiconductor device comprising:
   a substrate of a first conductivity type;
   a drift layer of the first conductivity type on the substrate;
   a plurality of cell stacks spaced apart by an interval on the drift layer, each of the plurality of cell stacks comprising a well region of a second conductivity type and a source region of the first conductivity type on the well region;
   a plurality of gate trenches extending into the drift layer and respectively extending through the source regions and the well regions of the plurality of cell stacks;
   a gate insulating layer on side surfaces of the plurality of cell stacks;
   a plurality of gate electrodes on the gate insulating layer;
   a plurality of cap regions of the first conductivity type below the gate insulating layer and in a section of respective gate trenches of the plurality of gate trenches that extends into the drift layer, each of the plurality of cap regions comprising at least one edge portion extending toward a respective well region of the plurality of cell stacks;
   a plurality of shield regions of the second conductivity type contacting the gate insulating layer and within respective cap regions of the plurality of cap regions;
   a source electrode connected to the source region of each of the plurality of cell stacks; and
   a drain electrode on a lower surface of the substrate.
Clause 7. The semiconductor device of Clause 6, wherein the cap region surrounds a portion of a respective shield region located below the plurality of respective cell stacks and at least one edge portion of the plurality of cap regions is respectively connected to the well region of the plurality of cell stacks.
Clause 8. A method of manufacturing a semiconductor device, the method comprising:
   forming a substrate structure comprising a substrate of a first conductivity type, a drift layer of the first conductivity type on the substrate, a well region of a second conductivity type on the drift layer, and a source region of the first conductivity type on the well region;
   forming a gate trench in the substrate structure using a mask, a region of the drift layer being open at a bottom of the gate trench;
   forming a cap region of the first conductivity type by ion-injecting a first conductivity-type impurity into the opened region of the drift layer, using the mask;
   removing the mask;
   forming a thermal oxide film on a surface of the substrate structure on which the gate trench is formed; and
   forming a shield region of the second conductivity type by ion-injecting a second conductivity-type impurity into a portion of the cap region of the first conductivity type, using the thermal oxide film.
Clause 9. The method of Clause 8, wherein a concentration of the first conductivity-type impurity injected into the cap region is greater than a concentration of the first conductivity-type impurity in the drift layer and less than a concentration of the second conductivity-type impurity in the well region.
Clause 10. The method of Clause 8 or Clause 9, wherein a concentration of the second conductivity-type impurity injected into the shield region is greater than a concentration of the first conductivity-type impurity in the cap region and less than a concentration of the first conductivity-type impurity in the source region.
Clause 11. The method of any of Clauses 8-10, wherein the cap region comprises an edge portion connected to the well region.
Clause 12. The method of Clause 11, further comprising performing annealing for activation after the forming the thermal oxide film,
   wherein, during the performing the annealing for activation, the well region is spaced apart from the cap region.
Clause 13. The method of any of Clauses 8-12, further comprising, after the forming the shield region of the second conductivity type:
   removing the thermal oxide film from the substrate structure;
   forming a gate insulating layer on an inner surface of the gate trench; and
   forming a gate electrode on the gate insulating layer within the gate trench.

While the disclosure has been particularly shown and described with reference to embodiments thereof, it will be understood that various changes in form and details may be made therein without departing from the scope of the following claims.

## Claims

1. A semiconductor device comprising:
a substrate (101) of a first conductivity type;
a drift layer (102) of the first conductivity type on the substrate (101);
a well region (105) of a second conductivity type on the drift layer (102);
a source region (107) of the first conductivity type on the well region (105);
a gate trench (GT) extending through the source region (107) and the well region (105), and extending into the drift layer (102);
a gate insulating layer (120) in the gate trench (GT);
a gate electrode (130) on the gate insulating layer (120);
a shield region (165) of the second conductivity type below the gate insulating layer (120) and in a section of the gate trench (GT) that extends into the drift layer (102);
a cap region (162) of the first conductivity type on a side of the shield region (165) and in the section of the gate trench (GT) that extends into the drift layer (102);
a source electrode (150) connected to the source region (107); and
a drain electrode (190) on a lower surface of the substrate (101).

2. The semiconductor device of claim 1, wherein a concentration of a first conductivity-type impurity in the cap region (162) is greater than a concentration of the first conductivity-type impurity in the drift layer (102) and less than a concentration of a second conductivity-type impurity in the well region (105).

3. The semiconductor device of claim 1 or claim 2, wherein a concentration of a first conductivity-type impurity in the cap region (162) is less than a concentration of the first conductivity-type impurity in the source region (107).

4. The semiconductor device of any preceding claim, wherein a concentration of a second conductivity-type impurity in the shield region (165) is greater than a concentration of a first conductivity-type impurity in the cap region (162) and less than a concentration of the first conductivity-type impurity in the source region (107).

5. The semiconductor device of any preceding claim, wherein a concentration of a second conductivity-type impurity in the shield region (165) is less than a concentration of the second conductivity-type impurity in the well region (105).

6. The semiconductor device of any preceding claim, wherein the cap region (162) extends along a sidewall of the gate trench (GT) and connects to the well region (105).

7. The semiconductor device of any of claims 1-5, wherein the cap region (162) comprises a portion extending along a sidewall of the gate trench (GT) toward the well region (105), and the well region (105) is spaced apart from the cap region (162).

8. The semiconductor device of any preceding claim, wherein the cap region (162) covers a bottom of the shield region (165).

9. The semiconductor device of any of claims 1-7, wherein a bottom of the shield region (165) contacts the drift layer (102).

10. The semiconductor device of claim 9, wherein a depth of the shield region (165) is greater than a depth of the cap region (162).

11. The semiconductor device of any preceding claim, wherein the gate electrode (130) comprises an upper surface at a level that is lower than a level of an upper surface of the source region (107).

12. The semiconductor device of any preceding claim, wherein the gate insulating layer (120) comprises a gate insulating film (121) on a sidewall of the gate trench (GT) and a bottom insulating portion (125), and the gate insulating film (121) has a first thickness that is smaller than a second thickness of the bottom insulating portion (125).

13. The semiconductor device of any preceding claim, wherein the substrate (101), the drift layer (102), and the well region (105) comprise silicon carbide.

14. A method of manufacturing a semiconductor device, the method comprising:
forming a substrate structure comprising a substrate (101) of a first conductivity type, a drift layer (102) of the first conductivity type on the substrate (101), a well region (105) of a second conductivity type on the drift layer (102), and a source region (107) of the first conductivity type on the well region (105);
forming a gate trench (GT) in the substrate structure using a mask (HM), a region of the drift layer (102) being open at a bottom of the gate trench (GT);
forming a cap region (162) of the first conductivity type by ion-injecting a first conductivity-type impurity into the opened region of the drift layer (102), using the mask (HM);
removing the mask (HM);
forming a thermal oxide film (170) on a surface of the substrate structure on which the gate trench (GT) is formed; and
forming a shield region (165) of the second conductivity type by ion-injecting a second conductivity-type impurity into a portion of the cap region (162) of the first conductivity type, using the thermal oxide film (170).

15. The method of claim 14, wherein a concentration of the first conductivity-type impurity injected into the cap region (162) is greater than a concentration of the first conductivity-type impurity in the drift layer (102) and less than a concentration of the second conductivity-type impurity in the well region (105).
